# EUROPÄISCHE PATENTSCHRIFT

(11) **EP 0 293 039 B1**
(45) Veröffentlichungstag und Bekanntmachung des Hinweises auf die Patenterteilung: **08.11.1995**
(21) Anmeldenummer: 88201005.1
(22) Anmeldetag: 19.05.1988
(51) Int. Cl.: H03F 1/26, H04B 1/18

(54) **Schaltungsanordnung mit einem Verstärker mit bipolaren Transistoren**
Bipolar transistor amplifier
Circuit amplificateur à des transistors bipolaires

(30) Priorität: 20.05.1987 DE 3716874
(43) Veröffentlichungstag der Anmeldung: 30.11.1988
(73) Patentinhaber: Philips Patentverwaltung GmbH, 22335 Hamburg (DE); Philips Electronics N.V., 5621 BA Eindhoven (NL)
(72) Erfinder: Dick, Burkhard, D-2000 Hamburg 61 (DE)
(74) Vertreter: Hartmann, Heinrich, Dipl.-Ing.

(56) Entgegenhaltungen:
- DE-A- 2 202 896
- DE-A- 2 229 279
- US-A- 4 186 360
- IEEE TRANSACTIONS ON MICROWAVE THEORY AND TECHNIQUES, Band MTT-30, Nr. 1 Januar 1982, Seiten 63-70, New York, US; K.B. NICLAS: "Noise in broad-band GaAs MESFET amplifiers with parallel feedback"
- PATENT ABSTRACTS OF JAPAN, Band 7, Nr. 62 (E-164)[1207], 15. März 1983;& JP - A - 57 207 412 (FUJITSU K.K.) 20.12.1982
- IEEE TRANSACTIONS ON INSTRUMENTATION AND MEASUREMENT, Band IM-32, Nr. 2, Juni 1983, Seiten 331-336, New York, US; E.H. NORDHOLT et al.: "The design of extremely low-noise camera-tube preamplifiers"
- PATENT ABSTRACTS OF JAPAN, Band 6, Nr. 77 (E-106)[955], 14. Mai 1982; & JP-A-57 15507 (MITSUBISHI DENKI K.K.) 26.01.1982
- PROCEEDINGS OF THE IEEE, Band 69, Nr. 6, June 1981, Seiten 728-741, New York, US; Y. NETZER: "The design of low-noise amplifiers"

## Beschreibung

Die Erfindung betrifft eine Schaltungsanordnung mit einem Verstärker, der von einer Signalquelle mit komplexem Innenwiderstand gespeist wird, die zwecks Rauschverminderung in Reihe mit einem Reaktanznetzwerk dem Verstärkereingang parallelgeschaltet ist, wobei die Reihenschaltung im Signalfrequenzbereich eine Serienresonanzfrequenz aufweist, mit einem Gegenkopplungspfad vom Ausgang des Verstärkers. Eine solche Schaltungsanordnung ist aus "Proceedings of the IEEE", Band 69, Nr. 6 "The Design of Low-Noise Amplifiers" im wesentlichen bekannt.

In dieser Literaturstelle ist angegeben, daß bei Signalquellen mit komplexem bzw. reaktivem Innenwiderstand das Rauschen durch Hinzufügung einer geeigneten Reaktanz, deren Art von der Natur der Signalquelle und der dominanten Rauschquelle abhängt, vermindert werden kann. Bei einer kapazitiven Signalquelle beispielsweise kann das Rauschen durch eine Serien- Parallelschaltung einer Induktivität in unterschiedlicher Weise beeinflußt werden. Bei der Parallelschaltung wird das Spannungsrauschen beeinflußt und bei der Serienschaltung das Stromrauschen. Dieser Einfluß ist im Resonanzfall am stärksten. In der Veröffentlichung ist weiter angegeben, daß der Verstärker auch Bipolartransistoren enthalten kann; allerdings enthält diese Veröffentlichung keine Aussagen darüber, welche der angegebenen Möglichkeiten (Parallel- oder Serienschaltung einer Reaktanz) für einen Verstärker mit bipolaren Transistoren vorzuziehen ist.

Der Veröffentlichung ist weiter zu entnehmen, daß sich durch diese Rauschminderungsmaßnahmen Signalverzerrungen ergeben können, die durch ein vergleichsweises komplexes Netzwerk zur Wiederherstellung des Signals beseitigt werden können. Wie ein solches Netzwerk aufgebaut ist, ist nicht angegeben.

Außerdem ist angegeben, daß der Verstärker mit einer Parallel- oder Seriengegenkopplung versehen sein kann. Diese beeinflußt aber die Signalquelle in gleicher Weise wie die Rauschquelle, so daß eine Entzerrung damit nicht möglich ist.

Aufgabe der vorliegenden Erfindung ist es, eine Schaltungsanordnung der eingangs genannten Art mit einem Verstärker mit bipolaren Transistoren so auszugestalten, daß in dem Signalübertragungsbereich das Rauschen am Ausgang ohne wesentliche Beeinflussung der Signalübertragung und ohne Beeinträchtigung der Stabilität verringert wird. Diese Aufgabe wird durch die im Hauptanspruch angegebenen Maßnahmen gelöst.

In einem Transistorverstärker hat das Rauschen des Eingangstransistors im allgemeinen den größten Einfluß auf das Gesamtrauschen des Verstärkers, wobei bei bipolaren Transistoren im allgemeinen das Stromrauschen dominiert. Der Einfluß dieses Stromrauschens auf das Ausgangssignal wird durch die Serienresonanz verringert. Die erfindungsgemäße Schaltungsanordnung ist daher mit Vorteil als rauscharme breitbandige Eingangsstufe von Quellen mit induktiver oder kapazitiver Generatorimpedanz einsetzbar.

Die Erfindung wird nachstehend anhand der Zeichnung näher erläutert. Es zeigen:
- Fig. 1: das Prinzipschaltbild einer erfindungsgemäßen Schaltung,
- Fig. 2: ein erstes Ausführungsbeispiel,
- Fig. 3: den Einsatz einer Schaltung nach Fig. 2 in einem Mittelwellenempfänger,
- Fig. 4a: bis 4c den Verlauf verschiedener für das Rauschen wesentlicher Parameter als Funktion der Frequenz bei einer Schaltung nach Fig. 2, und
- Fig. 5: ein anderes Ausführungsbeispiel der Erfindung.

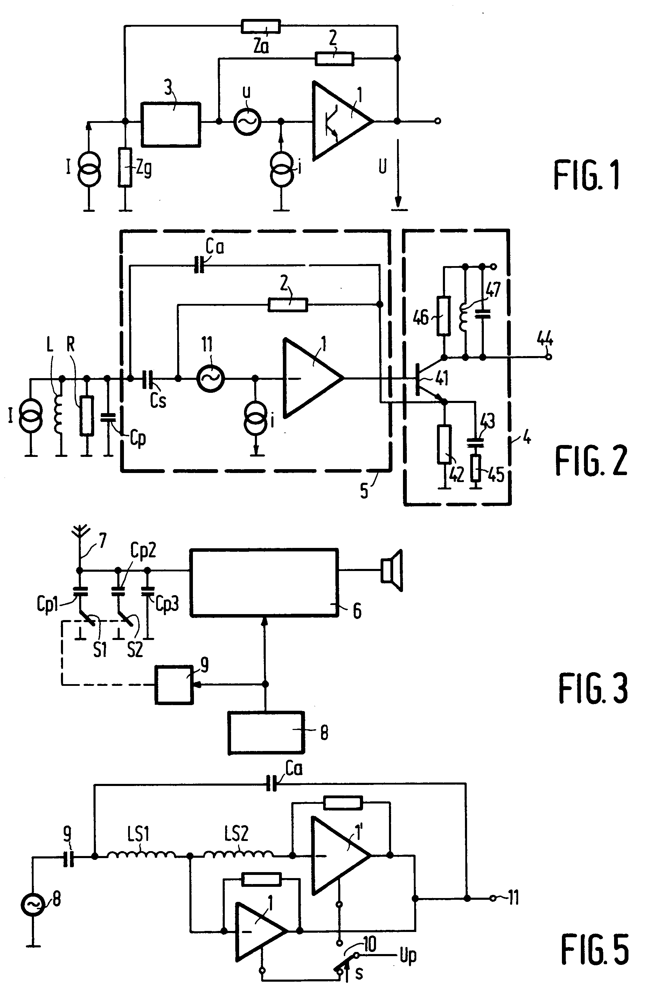

In Fig. 1 ist ein rauschender Verstärker durch ein Ersatzschaltbild aus einem rauschfreien Verstärker 1, einer in Serie zum (invertierenden) Eingang des Verstärkers wirksamen Rauschspannungsquelle u und einer mit diesem Eingang verbundenen Rauschstromquelle i dargestellt. Die von der Rauschquelle u bzw. i gelieferten Spannungen bzw. Ströme sind in der Regel statistisch unabhängige, nicht miteinander korrelierte Größen. Der Verstärker 1, dessen Aufbau nicht näher dargestellt ist, enthält bipolare Transistoren, bei denen bei genügend großer Quellenimpedanz in der Regel der Einfluß des Stromrauschens dominant ist.

Der Verstärkerausgang, an dem die Ausgangsspannung U abnehmbar ist, ist über einen gleichstromdurchlässigen Gegenkopplungspfad mit dem Verstärkereingang verbunden. Der Gleichstromgegenkopplungspfad enthält eine Impedanz 2, in der Regel einen hochohmigen ohmschen Widerstand, wobei davon ausgegangen ist, daß die dadurch hervorgerufene Rauschkomponente in der Rauschstromquelle i enthalten ist.

Es ist ein weiterer Gegenkopplungszweig vorgesehen, der den Ausgang über eine Impedanz Za mit einem Signalgenerator mit komplexem Generatorwiderstand verbindet. Der Generator ist in Fig. 1 als Ersatzschaltbild mit einer Signalstromquelle und einem dazu parallelgeschalteten komplexen Widerstand Zg dargestellt. Der ohmsche Anteil dieses Generatorwiderstandes sollte im Signalfrequenzbereich gegenüber seinem kapazitiven oder induktiven Blindanteil möglichst klein sein, damit der Einfluß des dadurch hervorgerufenenen Rauschens klein bleibt.

Der Verbindungspunkt der Signalquelle I, Zg und der Gegenkopplungsimpedanz Za ist über ein Reaktanznetzwerk 3 mit dem Eingang des Verstärkers 1 verbunden. Wäre dieses Reaktanznetzwerk nicht vorhanden, dann hätte der Verstärker für den Signalstrom I und den Rauschstrom i das gleiche Übertragungsverhalten. Durch das Reaktanznetzwerk werden Nutz- und Rauschquellen schaltungstechnisch so entkoppelt, daß in dem Signalübertragungsbereich das Rauschen am Ausgang ohne wesentliche Beeinflussung der Signalübertragung - und ohne Beeinträchtigung der Stabilität - verringert wird. Zu diesem Zweck ist bei vorgegebener Quellenimpedanz das Reaktanznetzwerk 3 in Verbindung mit der Gegenkopplungsimpedanz Za so dimensioniert, daß sich im Signalfrequenzbereich eine Serienresonanz ergibt, die den Rauschstrom i praktisch kurzschließt und damit dessen Einfluß auf das Verstärkerausgangssignal verringert. Da gleichzeitig durch die Gegenkopplung über die Impedanz Za die Signalübertragung im wesentlichen unbeeinflußt bleibt, ergibt sich eine Verbesserung des Signal-Rauschverhältnisses.

Dieses Prinzip wird nachstehend anhand zweier konkreter in Fig. 2 und Fig. 5 dargestellter Ausführungsbeispiele erläutert, wobei gleichartige Teile mit den gleichen Bezugszeichen versehen sind.

Fig. 2 zeigt eine breitbandige Eingangsstufe eines Mittelwellenempfängers mit einer induktiven Generatorimpedanz in Form einer Mittelwellenantenne. Die Generatorimpedanz ist in Fig. 2 als Ersatzschaltung aus einer Induktivität von 0,5 mH und einem ihr parallelgeschalteten Widerstand R von ca. 500 kOhm dargestellt. Die Impedanz Za wird durch einen Kondensator Ca von 5 pF gebildet, während das Reaktanznetzwerk 3 aus einem zu L und R parallelen Kondensator Cp sowie einem Kondensator Cs von 60 pF gebildet wird, der zwischen den Generator und den Verstärkereingang geschaltet ist. Der Verstärker besitzt einen Eingangswiderstand von 22 kOhm und bei 1 MHz eine Verstärkung von 38 dB, die im Mittelwellenbereich mit 20 dB/Dekade abnimmt.

Für die Rauschstromquelle i wirkt die Schaltung nach Fig. 2 wie ein Filter, das bei der Resonanzfrequenz der Induktivität L mit der Summe von Ca, Cs und Cp ein Übertragungsminimum (Serienresonanz) aufweist, wobei die Frequenz für dieses Minimum um so niedriger liegt, je größer die Kapazität des Kondensators Cp ist.

Für das Spannungsrauschen ergibt sich ebenfalls ein Minimum, jedoch bei der Resonanz der Induktivität L mit der Summe von Cp und Ca (d.h. dieses Minimum ist von der Kapazität des Kondensators Cs unabhängig). Dementsprechend liegt das Minimum für das Spannungsrauschen höher als das Minimum für das Stromrauschen (bei gleicher Kapazität Cp).

Durch die Frequenzabhängigkeit der Übertragung des Spannungs- und des Stromrauschens ergibt sich am Ausgang ein Gesamtrauschen, dessen Minimum zwischen den Minima für das Strom- und das Spannungsrauschen liegt. Dieses Minimum kann durch geeignete Wahl der Kapazität des Kondensators Cp an eine gewünschte Stelle im Übertragungsband gebracht werden.

Im Gegensatz dazu wird die Signalübertragung für den Generatorstrom I wegen der Gegenkopplung über den Kondensator Ca durch die Kapazität Cp praktisch nicht beeinflußt, und zwar selbst dann nicht, wenn diese Kapazität so gewählt ist, daß sie zusammen mit der Induktivität L eine Resonanz im Übertragungsbereich aufweist. Die Schleifenverstärkung nimmt in diesem Fall nämlich so zu, daß am Ausgang des Verstärkers keine Resonanzüberhöhung auftreten kann. Bei konstantem Generatorstrom I nimmt die Ausgangsspannung im Mittelwellenbereich, d.h. von 535 bis 1605 kHz, annähernd linear um ca. 10 dB ab. Die Ursache für diese Abnahme liegt in der mit wachsender Frequenz zunehmenden Gegenkopplung durch den Kondensator Ca.

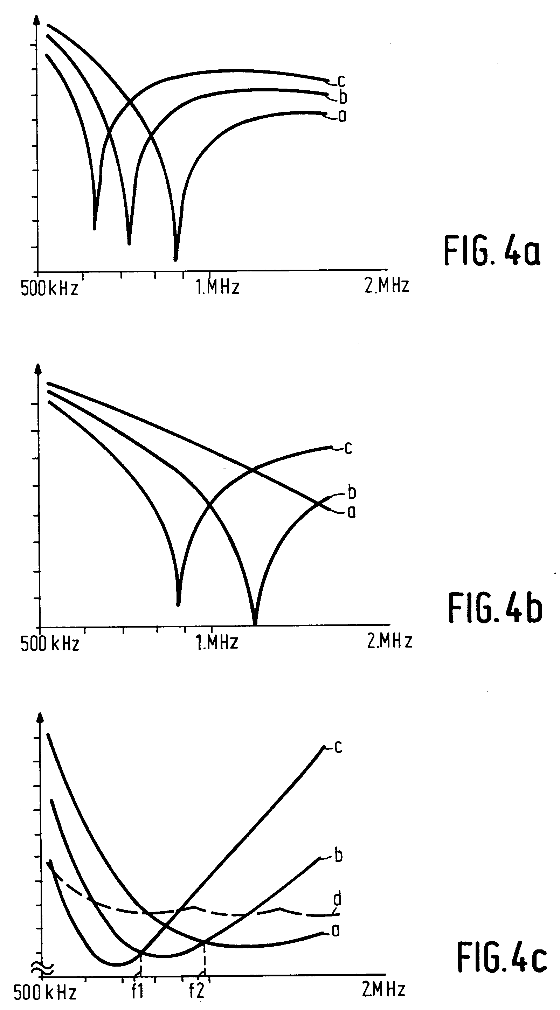

In Fig. 4a ist der Übertragungsfaktor für den Rauschstrom i (d.h. die durch den Rauschstrom am Ausgang des Verstärkers 1 hervorgerufene Spannung, dividiert durch den Rauschstrom i) in logarithmischem Maßstab als Funktion der Frequenz (ebenfalls in logarithmischem Maßstab) dargestellt, und zwar für verschiedene Kapazitätswerte von Cp. Die Kurve a ergibt sich für Cp = 2 pF, b ergibt sich für Cp = 30 pF und die Kurve c resultiert bei Cp = 60 pF. Das Minimum des Stromrauschens verschiebt sich also mit zunehmender Kapazität zu niedrigen Frequenzen.

Analog dazu zeigt Fig. 4b den Übertragungsfaktor für das Spannungsrauschen u als Funktion der Frequenz für die gleichen Kapazitätswerte. Das Minimum des Spannungsrauschens liegt, wie bereits erwähnt, höher als das Minimum des Stromrauschens, wobei das Minimum für Cp = 2 pF (Kurve a) außerhalb des Übertragungsbereiches liegt.

Fig. 4c zeigt das Gesamtrauschen, d.h. den äquivalenten Eingangsrauschstrom parallel zum Signalstrom, der am Ausgang einer identisch aufgebauten, aber rauschfreien Schaltung das gleiche Rauschen hervorrufen würde, das an der vorliegenden Schaltung auftritt, als Funktion der Frequenz, ebenfalls mit Cp als Parameter. Man erkennt relativ breite Rauschminima, die jedoch immer nur einen Teil des Mittelwellenbereichs erfassen.

Wie bereits erwähnt, hängt bei der Schaltung nach Fig. 2 auch die Verstärkung des Nutzsignals von der Frequenz ab. Um diese Frequenzabhängigkeit zu beseitigen, ist der erfindungsgemäßen Schaltung eine Kompensationsstufe 4 nachgeschaltet, die einen inversen Frequenzgang aufweist, so daß das Ausgangssignal dieser Stufe - bei konstantem Antennensignal - im wesentlichen frequenzunabhängig ist.

Diese Stufe kann beispielsweise aus einem bipolaren Transistor 41 bestehen, dessen Emitterwiderstand 42 für die Frequenzen des Mittelwellenbereiches durch die Serienschaltung eines Kondensators 43 von 150 pF und eines Widerstandes 45 von 500 Ohm überbrückt ist. Daraus resultiert eine kapazitive Emitterimpedanz mit einem ohmschen Anteil. Die Basis des Transistors 41 ist mit dem Ausgang des Verstärkers 1 verbunden, und der Emitter des Transistors 41 ist mit dem Kondensator Ca und dem Gleichstromwiderstand 2 verbunden. Der Widerstand 2 kann aber auch direkt mit dem Ausgang des Verstärkers 1 verbunden sein. Der Kollektor ist über einen Widerstand 46 an eine Versorgungsspannung angeschlossen, dem ein auf ca. 2 MHz abgestimmter Parallelresonanzkreis 47 parallelgeschaltet ist. Die Kollektorimpedanz wird dadurch induktiv mit einem ohmschen Anteil. Bei dieser Schaltung ergibt sich am Kollektor, der den Ausgang 44 der Schaltung bildet, ein nahezu frequenzunabhängiges Ausgangssignal.

Fig. 3 zeigt einen nach dem Prinzip von Fig. 2 aufgebaute Mittelwellenempfänger. Der Empfangsteil 6 enthält die Kompensationsschaltung 4, den in Fig. 2 gestrichelt umrahmten Teil 5 der erfindungsgemäßen Schaltung und weitere Signalverarbeitungskomponenten. Dem Antenneneingang 7 ist die Serienschaltung eines ersten Kondensators Cp1 und eines ersten Schalters S1 sowie die Serienschaltung eines zweiten Kondensators Cp2 und eines zweiten Schalters S2 parallelgeschaltet. Der zum Antenneneingang parallele Kondensator Cp3 stellt die Wicklungskapazität der Antenne dar. Wenn Cp1 und Cp2 je etwa 30 pF betragen, sind am Antenneneingang je nach Stellung der Schalter S1 und S2 entweder 2 pF, 32 pF oder 62 pF wirksam.

Die Schalter S1 und S2 werden durch eine Logikschaltung 9 betätigt, die ihrerseits durch die Abstimmeinheit 8 des Empfängers 6 gesteuert wird, der zugleich auch die Abstimmfrequenz des Empfängers 6 festlegt. Die Logikschaltung 9 leitet aus den Abstimmdaten der Abstimmeinheit 8, z.B. den Frequenzteilerfaktoren für eine im Empfangsteil 6 enthaltene PLL-Schaltung, die Schaltsignale für die Schalter S1 und S2 ab. Die Schaltung 9 ist so ausgelegt, daß bei niedrigen Mittelwellenfrequenzen bis etwa zur Frequenz f1 (vgl. Fig. 4c) die beiden Schalter geschlossen sind, so daß bis zu dieser Frequenz das Rauschen gemäß Kurve c verläuft. Zwischen der Empfangsfrequenz f1 und f2 ist einer der beiden Schalter S1, S2 geöffnet und der andere geschlossen. Am Eingang ergibt sich dann eine Kapazität von ca. 32 pF mit dem Verlauf des Rauschens gemäß Kurve b, das in diesem Frequenzbereich niedriger ist als das Rauschen gemäß Kurve c oder a.

Entsprechend werden oberhalb der Frequenz f2, bei der sich die Kurven a und b schneiden, beide Schalter S1 und S2 geöffnet, so daß nur noch die Kapazität Cp3 von 2 pF am Antenneneingang wirksam ist. Das Rauschen ergibt sich dann gemäß Kurve a in Fig. 4c. Durch diese Umschaltung wird also erreicht, daß am Eingang immer diejenige Kapazitätskombination wirksam ist, die das niedrigste Rauschen ergibt.

Zum Vergleich ist in Fig. 4c mit gestrichelten Linien die Kurve d für das Gesamtrauschen dargestellt, die sich ergeben würde, wenn der Kondensator Cs nicht vorhanden wäre, die Schalter S1 und S2 in Abhängigkeit von der Abstimmfrequenz aber so umgeschaltet würden, daß sich ein Rauschminimum ergäbe. Man erkennt deutlich die durch die Erfindung bewirkte Verbesserung.

Wie bereits erwähnt wurde, kann bei einer Schaltung nach Fig. 2 die durch den Kondensator Cp in Verbindung mit der induktiven Impedanz L des Generators bedingte Parallelresonanz wegen der Gegenkopplung über Ca nicht zu Resonanzüberhöhungen führen. Infolgedessen bleiben bei der Schaltung nach Fig. 3 der Strom durch die Schalter S1 und S2 immer relativ gering, so daß deren endlicher Widerstand (insbesondere bei Ausführung als Halbleiterschalter) zu nur unwesentlichen Signalverlusten führt. Es kommt hinzu, daß durch die Umschaltung sichergestellt wird, daß der aus der Induktivität L und der dazu parallelen Kapazität Cp bestehende Parallel-Resonanzkreis stets unterhalb seiner Resonanzfrequenz betrieben wird, so daß auch deshalb Resonanzeffekte vermieden werden.

Die durch die Erfindung bewirkte Verringerung des Rauschens beim Mittelwellenempfänger ist zwar nicht so groß wie sie bei einem Empfänger wäre, bei dem der Antenneneingang stets auf die Empfangsfrequenz abgestimmt wäre. Ein solcher Empfänger würde aber entweder einen relativ teuren Drehkondensator oder eine Kapazitätsdiode voraussetzen, die relativ große Abstimmspannungen benötigt. Außerdem wäre bei einem solchen Empfänger ein genauer Abgleich zwischen Oszillator- und Eingangskreis erforderlich. Die Erfindung kann demgegenüber auch -insbesondere als integrierte Schaltung - bei Empfängern eingesetzt werden, die eine geringe Versorgungsspannung (z.B. 3 V) haben. Ein Abgleich ist nicht erforderlich.

Obwohl die Schaltung nach Fig. 2 in Verbindung mit einem Mittelwellenempfänger erläutert wurde, kann sie auch in anderen Fällen als breitbandige Eingangsstufe dienen, wenn nur der Signalgenerator einen im wesentlichen induktiven Generatorwiderstand aufweist, wie beispielsweise der Wiedergabekopf eines Magnetbandgerätes. In diesem Fall muß die Dimensionierung des Reaktanznetzwerkes Cs, Cp (und des Gegenkopplungskondensators Ca) den Erfordernissen einer solchen Schaltung angepaßt werden.

Fig. 5 erläutert die Erfindung am Beispiel einer breitbandigen Eingangsstufe für kapazitive Signalgeneratoren, wie beispielsweise eine kapazitive Antenne. Die Signalquelle ist in diesem Fall als Ersatzschaltbild durch die Serienschaltung eines Signalspannungsgenerators 8 und eines Kondensators 9 dargestellt. Die Signalquelle ist über eine erste Induktivität LS1 mit dem Eingang eines ersten Verstärkers 1 verbunden (dessen Eingangs-Rauschquellen nicht gesondert dargestellt sind). Der Ausgang dieses Verstärkers ist über einen Kondensator Ca mit dem Verbindungspunkt des Generators 8, 9 und der ersten Induktivität LS1 verbunden. Die Induktivität LS1 ist so bemessen, daß sich im Signalübertragungsbereich eine Serienresonanz ergibt, die das durch die (nicht näher dargestellte) Rausch-Stromquelle verursachte Rauschen am Ausgang 11 der Schaltung reduziert.

Eine Parallelresonanz ergibt sich bei der Schaltung nach Fig. 5 nicht, so daß das Spannungsrauschen praktisch nicht beeinflußt wird. Da das Stromrauschen bei einem Verstärker mit bipolaren Transistoren bei genügend großer Generatorimpedanz jedoch ohnehin überwiegt, ist dies kein wesentlicher Nachteil. Dafür ist die Schaltung wegen der kapazitiven Gegenkopplung in Verbindung mit dem kapazitiven Generator frequenzunabhängig.

Ähnlich wie bei der Schaltung nach Fig. 1 wird das Rauschen nur in einem bestimmten Frequenzbereich um die Resonanzstelle herum beeinflußt. Um bei einer Empfängerschaltung das Rauschen in einem breiteren Frequenzbereich zu unterdrücken, müßte das Reaktanznetzwerk bei der Schaltung nach Fig. 5 in ähnlicher Weise umgeschaltet werden wie bei Fig. 3. Zu diesem Zweck ist mit dem Eingang des ersten Verstärkers 1 eine zweite Induktivität LS2 verbunden, deren anderer Anschluß an den invertierenden Eingang eines weiteren Verstärkers 1′ angeschlossen ist, der die gleichen Eigenschaften hat wie der Verstärker 1. Der Ausgang dieses Verstärkers ist mit dem Ausgang des Verstärkers 1 verbunden. Die Versorgungsspannungsanschlüsse der Verstärker 1, 1′ sind über einen Umschalter an eine Versorgungsspannungsquelle angeschlossen, so daß immer nur einer der beiden Verstärker wirksam ist.

Bei Abstimmung auf einen niedrigeren Frequenzbereich ist der Umschalter 10 mit dem Versorgungsspannungsanschluß des Verstärkers 1′ verbunden, wobei das Reaktanznetzwerk durch die Serienschaltung der beiden Induktivitäten LS1 und LS2 gegeben ist. Hierdurch wird das Rauschen im niedrigeren Frequenzbereich verringert. Bei Abstimmung auf einen höheren Frequenzbereich wird der Umschalter 10 durch ein Steuersignal s (das in analoger Weise erzeugt werden kann wie die Schaltsignale für die Schalter S1, S2 bei der Schaltung nach Fig. 3) in die in Fig. 5 dargestellte Schaltstellung umgeschaltet. In diesem Fall ist nur noch die Induktivität LS1 wirksam.

Auch hierbei wird aufgrund der Gegenkopplung vom Ausgang 11 über Ca zur Signalquelle die Signalübertragung durch die Induktivitäten LS1 und LS2 praktisch nicht beeinflußt.

Die Ausführungsform nach Fig. 5 ist ebenfalls nicht auf Empfängerschaltungen mit kapazitiver Antenne beschränkt. Sie kann vielmehr in all den Fällen eingesetzt werden, in denen ein Generator mit im wesentlichen kapazitivem Generatorwiderstand vorgegeben ist, z.B. ein Kondensatormikrofon.

## Patentansprüche

1. Schaltungsanordnung mit einem Verstärker (1) mit bipolaren Transistoren, und einer Signalquelle (I) mit komplexem Innenwiderstand (Zg), wobei die Signalquelle (I) zwecks Rauschminderung mit einem ersten Ansschluß eines Reaktanznetzwerkes (3) verbunden ist, von welchem ein zweiter Anschluß mit dem Verstärkereingang verbunden ist,
wobei ein erster Signalgegenkopplungspfad (Za) vom Ausgang des Verstärkers (1) zum ersten Anschluß des Reaktanznetzwerkes führt,
und ein zweiter Signalgegenkopplungspfad (2), der gleichstromdurchlässig ist, vom Ausgang des Verstärkers (1) zum zweiten Anschluß des Reaktanznetzwerkes (3) führt,
wobei die Zusammenschaltung der Signalquelle (I) mit dem Reaktanznetzwerks (3) und dem Signalgegenkopplungspfad (Za) im Signalfrequenzbereich eine Serienresonanz aufweist die den Rauschstrom der durch einen Eingangstransistor des Verstärkers verursacht wird praktisch kurzschließt.

2. Schaltungsanordnung nach Anspruch 1, wobei die Signalquelle einen induktiven Innenwiderstand aufweist,
dadurch gekennzeichnet, daß das Reaktanznetzwerk einen zwischen die Signalquelle (I) und den Verstärkereingang geschalteten ersten Kondensator (Cs) enthält.

3. Schaltungsanordnung nach Anspruch 2,
dadurch gekennzeichnet, daß der Signalquelle ein zweiter Kondensator (Cp) parallelgeschaltet ist.

4. Schaltungsanordnung nach Anspruch 1, wobei die Signalquelle einen kapazitiven Widerstand aufweist,
dadurch gekennzeichnet, daß das Reaktanznetzwerk aus einer zwischen die Signalquelle und den Verstärkereingang geschalteten Induktivität (LS1, LS2) besteht.

5. Schaltungsanordnung nach einem der Ansprüche 1 bis 4,
dadurch gekennzeichnet, daß im ersten Signalgegenkopplungspfad ein Kondensator (Ca) vorgesehen ist.

6. Schaltungsanordnung nach Anspruch 3 für einen abstimmbaren Empfänger,
dadurch gekennzeichnet, daß dem zweiten Kondensator ein in Abhängigkeit von der Abstimmfrequenz betätigbarer Schalter in Serie geschaltet ist.

7. Schaltungsanordnung nach Anspruch 6,
dadurch gekennzeichnet, daß dem zweiten Kondensator und dem Schalter mindestens eine weitere aus einem Kondensator in Serie mit einem Schalter bestehende Serienschaltung parallelgeschaltet ist.

8. Schaltungsanordnung nach Anspruch 4 für einen abstimmbaren Empfänger,
dadurch gekennzeichnet, daß die Induktivität aus mehreren in Serie geschalteten Spulen (LS1, LS2) besteht, wobei die Verbindungspunkte der Spulen und ihr von der Signalquelle abgewandter Anschluß mit dem Eingang je eines Verstärkers (1, 1′) verbunden sind, wobei die Versorgungsspannung jeweils eines der Verstärker in Abhängigkeit von der Abstimmfrequenz abschaltbar ist.

9. Schaltungsanordnung nach Anspruch 2 und 5,
dadurch gekennzeichnet, daß der Schaltungsanordnung eine Kompensationsstufe (4) nachgeschaltet ist, die einen zur Schaltungsanordnung inversen Frequenzgang aufweist.

10. Schaltungsanordnung nach Anspruch 9,
dadurch gekennzeichnet, daß die Kompensationsstufe einen Transistor (41) mit kapazitiver Emitterimpedanz (42, 43, 45) und induktiver Kollektorimpedanz (46, 47) enthält, daß die Basis des Transistors an den Ausgang des Verstärkers (1) angeschlossen ist, daß der Gegenkopplungs-Kondensator (Ca) an den Emitter angeschlossen ist, und daß der Kollektor des Transistors (41) den Ausgang (44) der Kompensationsstufe bildet.

## Claims

1. A circuit arrangement comprising an amplifier (1) with bipolar transistors (1), a signal source (I) with a complex internal resistance (Zg), the signal source (I) being connected to a first terminal of a reactance network (3), which has a second terminal connected to the amplifier input,
a first signal negative feedback path (Za) leading from the output of the amplifier (1) to the first terminal of the reactance network, and
a second signal negative feedback path (2), which transmits direct current, leading from the output of the amplifier (1) to the second terminal of the reactance network (3),
the combination of the signal source (I) withe the reactance network (3) and the signal negative feedback path (Za) having a series resonance in the signal frequency range, which substantially short-circuits the noise current caused by the one input transistor of the amplifier.

2. A circuit arrangement as claimed in Claim 1, in which the signal source has an inductive internal resistance,
characterised in that the reactance network comprises a first capacitor (Cs) arranged between the signal source (I) and the amplifier input.

3. A circuit arrangement as claimed In Claim 2,
characterised in that a second capacitor (Cp) is arranged in parallel with the signal source.

4. A circuit arrangement as claimed in Claim 1, in which the signal source has a capacitive resistance,
characterised in that the reactance network comprises an inductance (LS1, LS2) arranged between the signal source and the amplifier input.

5. A circuit arrangement as claimed in any one of Claims 1 to 4,
characterised in that a capacitor (Ca) is arranged in first the signal negative feedback path.

6. A circuit arrangement as claimed in Claim 3, for a tunable receiver,
characterised in that a switch which can be activated in dependence upon the tuning frequency is arranged in series with the second capacitor.

7. A circuit arrangement as claimed in Claim 6,
characterised in that at least a further series arrangement comprising a capacitor in series with a switch is arranged in parallel with the second capacitor and the switch.

8. A circuit arrangement as claimed in Claim 4 for a tunable receiver,
characterised in that the inductance comprises a plurality of series-connected coils (LS1, LS2), the nodes between the coils and their terminals remote from the signal source are connected to the respective input of an amplifier (1, 1′), the power supply voltage of each one of the amplifiers being disconnectable in dependence upon the tuning frequency.

9. A circuit arrangement as claimed in Claims 2 and 5,
characterised in that the circuit arrangement is followed by a compensation stage (4) having a frequency response which is inverted relative to that of the circuit arrangement.

10. A circuit arrangement as claimed in Claim 9,
characterised in that the compensation stage comprises a transistor (41) with a capacitive emitter impedance (42, 43, 45) and an inductive collector impedance (46, 47), in that the base of the transistor is connected to the output of the amplifier (1), in that the negative feedback capacitor (Ca) is connected to the emitter, and in that the collector of the transistor (41) constitutes the output (44) of the compensation stage.

## Revendications

1. Montage de circuit comportant un amplificateur (I) à transistors bipolaires, et une source de signaux (I) à résistance interne complexe (Zg), la source de signaux (I) étant connectée à des fins de réduction de bruit à une première borne d'un réseau de réactance (3), dont une deuxième borne est connectée à l'entrée de l'amplificateur,
un premier trajet de contre-réaction de signaux (Za) allant de la sortie de l'amplificateur (1) à la première borne du réseau de réactance,
et un deuxième trajet de contre-réaction de signaux (2), qui laisse passer le courant continu, allant de la sortie de l'amplificateur (1) à la deuxième borne du réseau de réactance (3),
l'interconnexion de la source de signaux (I) avec le réseau de réactance (3) et le trajet de contre-réaction de signaux (Za) présentant, dans le domaine des fréquences de signaux, une résonance sérielle qui court-circuite pratiquement le courant de bruit qui est suscité par un transistor d'entrée de l'amplificateur.

2. Circuit selon la revendication 1, dans lequel la source de signaux présente une résistance interne inductive, caractérisé en ce que le réseau de réactance contient un premier condensateur (Cs) entre la source de signaux (I) et l'entrée de l'amplificateur.

3. Montage de circuit selon la revendication 2, caractérisé en ce qu'un deuxième condensateur (Cp) est monté en parallèle avec la source de signaux.

4. Montage de circuit selon la revendication 1, dans lequel la source de signaux présente une résistance capacitive, caractérisé en ce que le réseau de réactance est constitué d'une inductance (LS1, LS2) montée entre la source de signaux et l'entrée de l'amplificateur.

5. Montage de circuit selon l'une quelconque des revendications 1 à 4, caractérisé en ce qu'un condensateur (Ca) est prévu dans le premier trajet de contre-réaction de signaux.

6. Montage de circuit selon la revendication 3 pour un récepteur accordable, caractérisé en ce qu'un commutateur est monté en série avec le deuxième condensateur, ledit commutateur pouvant être actionné en fonction de la fréquence d'accord.

7. Montage de circuit selon la revendication 6, caractérisé en ce qu'au moins un autre montage en série constitué d'un condensateur en série avec un commutateur est connecté en parallèle avec le deuxième condensateur et le commutateur.

8. Montage de circuit selon la revendication 4 pour un récepteur accordable, caractérisé en ce que l'inductance est constituée de plusieurs bobines (LS1, LS2) montées en série, les points de connexion des bobines et leur borne opposée à la source de signaux étant raccordés à l'entrée respective d'un amplificateur (1, 1′), de sorte que la tension d'alimentation, de chaque fois l'un des amplificateurs peut être coupée en fonction de la fréquence d'accord.

9. Montage de circuit selon les revendications 2 et 5, caractérisé en ce qu'en aval du montage de circuit est monté un étage de compensation (4) qui présente une réponse en fréquence inverse de celle du montage de circuit.

10. Montage de circuit selon la revendication 9, caractérisé en que l'étage de compensation contient un transistor (41) avec une impédance d'émetteur capacitive (42, 43, 45) et une impédance de collecteur inductive (46, 47), en ce que la base du transistor est connectée à la sortie de l'amplificateur (1), en ce que le condensateur de contre-réaction (Ca) est connecté à l'émetteur et en ce que le collecteur du transistor (41) forme la sortie (44) de l'étage de compensation.
